Europäisches Patentamt

European Patent Office

Office européen des brevets

(11) Veröffentlichungsnummer : **0 040 753**
**B1**

(12) **EUROPÄISCHE PATENTSCHRIFT**

(45) Veröffentlichungstag der Patentschrift :
01.10.86

(51) Int. Cl.⁴ : **H 05 K   5/00, H 05 K   9/00**

(21) Anmeldenummer : 81103652.4

(22) Anmeldetag : 12.05.81

(54) Isolierter Einschub mit hoher Spannungsfestigkeit.

(30) Priorität : 22.05.80 DE 3019645

(43) Veröffentlichungstag der Anmeldung :
02.12.81 Patentblatt 81/48

(45) Bekanntmachung des Hinweises auf die Patenterteilung : 01.10.86 Patentblatt 86/40

(84) Benannte Vertragsstaaten :
**DE FR GB NL SE**

(56) Entgegenhaltungen :
EP-A- 0 040 752
DE-A- 1 791 205
DE-A- 2 808 997
DE-B- 1 276 684
DE-B- 2 434 890
FR-A- 2 316 834
US-A- 4 012 089
US-A- 4 251 853

(73) Patentinhaber : **Siemens Aktiengesellschaft Berlin
und München
Wittelsbacherplatz 2
D-8000 München 2 (DE)**

(72) Erfinder : **Rosenfeldt, Bernd
Bunsenstrasse 33
D-8520 Erlangen (DE)**
Erfinder : **Weller, Gerhard
Wacholderweg 13
D-8520 Erlangen (DE)**
Erfinder : **Reis, Edmund
Richterstrasse 55
D-8520 Erlangen (DE)**

**Beschreibung**

Die Erfindung bezieht sich auf einen isolierten Einschub von hoher Spannungsfestigkeit zum Einschieben in die Kammer eines Gerätegehäuses, mit einem Mantelgehäuse aus hochisolierendem Kunststoff, das eine metallische Abschirmung und innerhalb dieser Abschirmung Bauelemente enthält, die zur Energie- und/oder Signalübertragung vorgesehen sind. Ein solcher Einschub ist aus der DE-U 77 36 156 bekannt.

Aufgabe der Erfindung ist es, einen Einschub der eingangs genannten Art anzugeben, der bei einfachem und kompaktem Aufbau optimal isoliert und spannungsfest ist und der leicht zusammengebaut werden kann.

Diese Aufgabe ist erfindungsgemäß dadurch gelöst, daß im Mantelgehäuse ein Schichtpaket angeordnet ist, das zwei metallische Abschirmbleche, z. B. aus Aluminium oder Stahlblech, und zwei nach Sandwich-Art dazwischen gelagerte Leiterplatten als Träger für die zur Energie- und/oder Signalübertragung vorgesehenen Bauelemente umfaßt, daß das Mantelgehäuse nur an seiner Frontseite offen ist und dort eine Frontöffnung bildet, daß zum Abschluß der Frontöffnung eine Frontplatte vorgesehen ist, die in ihren Abmessungen dicht in die Frontöffnung paßt, daß die Leiterplatten vorderseitig an der Frontplatte und rückseitig an einem Rückteil montiert sind, daß die beiden metallischen Abschirmbleche teilweise in Steckverbindung und teilweise in Schraubverbindung mit der Frontplatte und dem Rückteil verbunden sind, und daß das Schichtpaket samt Rückteil in das Mantelgehäuse einschiebbar ausgebildet ist.

Weitere Vorteile und Einzelheiten der Erfindung ergeben sich aus der nachfolgenden Beschreibung eines Ausführungsbeispieles anhand der Zeichnung in Verbindung mit den Unteransprüchen.

Es zeigen :

Figur 1 ein Gerät zur Signalübertragung und -verarbeitung in Schrägansicht,

Figur 2 einen aus zwei Halbschalen aufgebauten Isolierkörper,

Figur 3 den Isolierkörper mit montierter Rückplatte in teilgebrochener Ansicht,

Figur 4 eine Seitenansicht des Isolierkörpers mit einem Arretierhebelsystem für die Einschübe im Isolierkörper,

Figur 5 einen erfindungsgemäßen Einschub in Schrägansicht,

Figur 6 die Rückwand des Einschubes gemäß Figur 5,

Figur 7 einen Auswerfmechanismus für Einschübe an der Rückfläche des Isolierkörpers,

Figur 8 den inneren Aufbau eines Einschubes,

Figur 9 ein Koppelglied für Energiekopplung, teilweise im Schnitt.

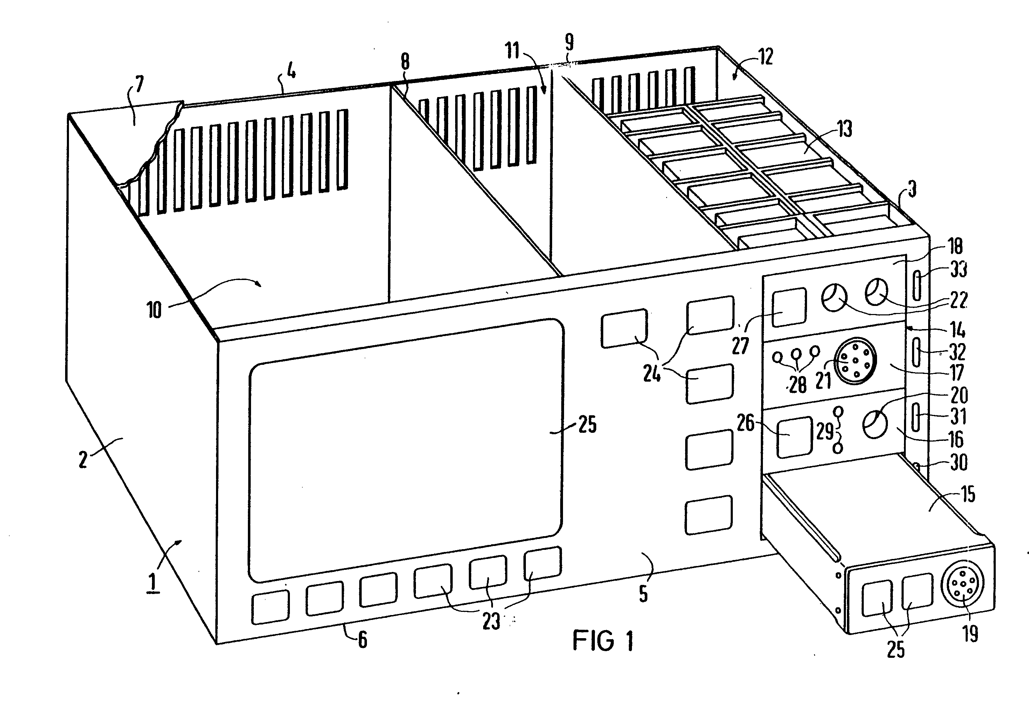

Figur 1 zeigt ein Signalübertragungs- und -verarbeitungsgerät mit einem im Zollmaß aufgebauten Gerätegehäuse 1 mit den Seitenwänden 2 und 3, der Rückwand 4 und Frontfläche 5, der Grundfläche 6 sowie der nur gebrochen angedeuteten Deckfläche. 7. Das Gerätegehäuse 1 ist durch z. B. zwei Zwischenwände 8, 9 in seinem Inneren in drei Kammern 10, 11 und 12 unterteilt. In der Kammer 10 sitzt beispielsweise eine (nicht dargestellte) Kathodenstrahlröhre zur Darstellung von Signalen. Die Kammer 11 nimmt z. B. Leiterplatten mit Bauelementen zur Signalverarbeitung bzw. Signalanzeige auf. Die Kammer 12 dient zur Aufnahme eines Isolierkörpers 13, der als frontseitig offener Kasten ausgebildet ist, in dessen Inneren von der Frontöffnung 14 her insgesamt vier Geräteeinschübe 15, 16, 17 und 18 einschiebbar sind. Die Kammer 12 des Gerätegehäuses 1 kann damit also als « Einbuchtung » definiert werden. Sie ist mit einem Isolierkörper 13 ausgekleidet, der wiederum zur Aufnahme der Einschübe 15 bis 18 dient. Ebensogut kann jedoch auch der Isolierkörper 13 selbst als « Einbuchtung » bezeichnet werden, die zur Aufnahme der Geräteeinschübe 15 bis 18 dient. Die Geräteeinschübe 15 bis 18 sind Bestandteil des Signalübertragungsgeräts. Sie können im Inneren schaltungsmäßig so aufgebaut sein, wie beispielsweise im DE-GM 77 36 156 (bzw. DE-PS 27 52 783) ausführlich beschrieben ist. Wesentlich ist, daß jeder Einschub 15 bis 18 einen Mantel aus Isolationsmaterial hoher Spannungsfestigkeit aufweist, der in seinem Inneren neben den Leiterplatten mit Bauelementen und Metallabschirmung für diese Bauelemente auch noch die ersten Halbglieder einer Koppelstelle für Energie- und Signalübertragung trägt, während die dazu passenden zweiten Halbglieder in der Rückfläche des Isolierkörpers 13 mit Verbindung zum freien Raum der Kammer 12 sitzen, wie im Detail später noch erläutert wird.

Das in der Figur 1 dargestellte Gerät ist speziell ein elektromedizinisches Gerät. Die Einschübe 15 bis 18 sind also Teil des Signalübertragungssystems für physiologische Signale, die mittels geeigneter Abnehmer am Körper eines Patienten abgenommen werden. Zu diesem Zweck werden (nicht dargestellte) Abnehmer am Körper des Patienten positioniert und über ein Signalkabel (ebenfalls nicht dargestellt) am jeweiligen Einschub 15 bis 18 angekoppelt. Die Einschübe 15 bis 18 weisen zu diesem Zweck Steckbuchsen 19 bis 22 für die entsprechenden Stecker der Signalkabel auf. Selbstverständlich ist auch der Einsatz von Einschüben möglich, bei denen die Abnehmer über Signalkabel mit dem jeweiligen Einschub immer fest (also nicht in Steckverbindung) verbunden sind. Letzterer Fall bietet sich an wenn das einzelne Einschubgehäuse relativ kleinvolumig ausgebildet ist. Der Einschub mit dem fest angeschlossenen Kabel ist dann selbst als Gerätestecker aufzufassen.

Im Ausführungsbeispiel der Figur 1 ist die Frontplatte 5 speziell als Folienplatte ausgebildet. Sämtliche Bedienungs- und/oder Anzeigeelemente liegen also in der Ebene der Folie, wie durch die Symbole 23, 24 angedeutet ist. Dasselbe gilt auch für das Bildfenster 25 für den Bildschirm der zu montierenden Kathodenstrahlröhre bzw. auch für die Frontflächen der eingeschobenen Einschübe 15 bis 18. Auch die Frontflächen der Einschübe 15 bis 18 liegen damit zusammen mit den ebenfalls nur schematisch dargestellten eingebauten Bedien- und Anzeigeelementen 25 bis 29 (28 und 29 sind z. B. Leuchtdioden) in der Folienebene der Frontplatte 5. Die Anordnung in einer Ebene verbietet das Anbringen von Griffen an den Einschüben 15 bis 18, mit deren Hilfe eingesteckte Einschübe aus der « Einbuchtung » des Gerätegehäuses 1 wieder herausgezogen werden können. Um dennoch ein schnelles Auswechseln von Einschüben 15 bis 18 gewährleisten zu können, ist jeder Einschub 15 bis 18 speziell mit einem Auswerfmechanismus an der Rückwand des Isolierkörpers 13 versehen, der in Aktion tritt, wenn eine Arretiervorrichtung, die den Einschub 15 bis 18 im Hohlraum nach Einschieben arretiert, durch manuelle Betätigung einer am Gerätegehäuse 1 angeordneten Ausklinktaste gelöst wird. Die einzelnen Ausklinktasten für die Einschübe 15 bis 18 sind in der Figur 1 an der äußeren rechten Kante der Frontplatte 5 mit den Kennziffern 30 bis 33 angedeutet. Weitere Details hinsichtlich Aufbau und Funktionsweise des Auswerfmechanismus in Verbindung mit der Arretiervorrichtung werden weiter unten beschrieben. In dem Ausführungsbeispiel der Figur 1 ist 15 beispielsweise ein $CO_2$-Einschub, 16 ein Einschub für Druckmessung, 17 ein Einschub für EKG-Messung und 18 ein Temperatureinschub. Selbstverständlich ist auch der Einsatz eines Einschubes für eine andere Meßgröße möglich.

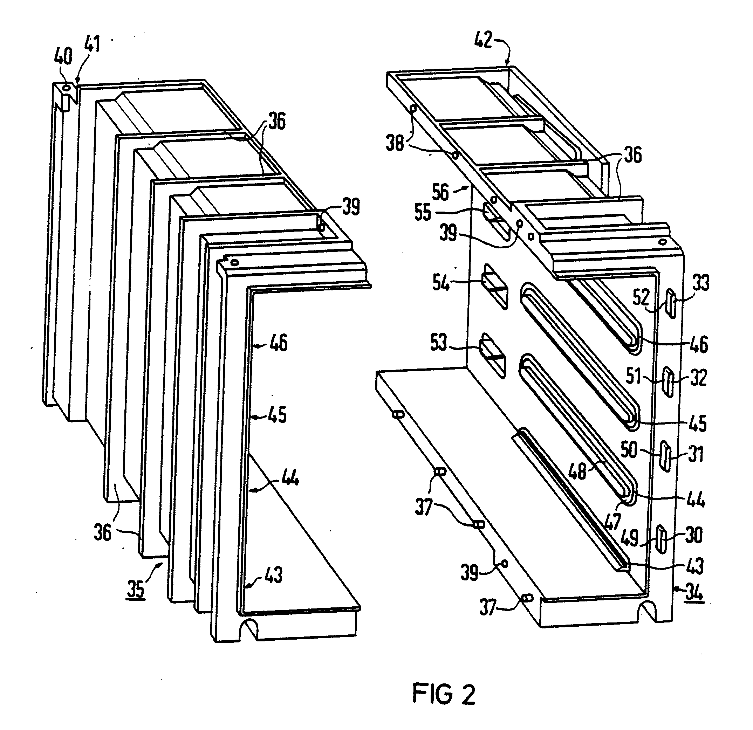

Gemäß Figur 2 setzt sich der Umfang des Isolierkörpers 13 aus zwei Halbschalen 34 und 35 zusammen. Beide Halbschalen 34, 35 sind aus dem Kunststoff Amino-Butadien-Styrol (ABS) gefertigt, der sich leicht formen läßt und zudem auch relativ preisgünstig ist. Um bei relativ großer Außenfläche des Isolierkörpers 17 mit möglichst wenig Isoliermaterial auszukommen, sind die beiden Halbschalen 34 und 35 als Rippenkörper geformt. Jede der Schalen 34 und 35 umfaßt also an ihrem Umfang Rippen 36, die die Innenwandung des Isolierkörpers 13 unter Einschluß von Isolierschichten aus Luft zwischen den Rippen in vorgebbarem Abstand von den Metallwänden der Gehäusekammer 12 halten. Im vorliegenden Fall beträgt die Tiefe der Rillen insbesondere an den Seitenwänden der Halbschalen 34, 35 ca. 7 mm. An den Ober- und Unterflächen der Halbschalen 34, 35 sinkt die Tiefe aus montagetechnischen Gründen auf einen Wert bis etwa 3 mm. Die Dicke der Rippen beträgt ca. 1,5 mm. Die Materialbreite der Innenwandung der Halbschalen 34, 35 beträgt ca. 3 mm. Der aus beiden Halbschalen 34 und 35 zusammengesetzte Isolierkörper 13 besitzt eine Außenbreite von 2/8″, von Außenrippen zu Außenrippen gemessen. Die Höhe des kastenförmigen Isolierkörpers 13 liegt bei ca. 180 mm (entsprechend vier Höheneinheiten HE). Diese Bemessung des Isolierkörpers 13 und die Auswahl des verwendeten isolierenden Kunststoffes führen im vorliegenden Ausführungsbeispiel dazu, daß die Kapazität zwischen Metallteilen innerhalb des Gehäuses der Einschübe 15 bis 18 und Metallteilen außerhalb des Isolierkörpers 13 (Abschirmwände der Kammer 12 des Gerätegehäuses 1 bzw. an der Rückwand des Isolierkörpers 13 befindliche Metallteile), bezogen auf eine Betriebsspannung von 220 V und 50 Hz, auf einen Wert < 130 pF begrenzt wird. Bei dieser Kapazität ist ein möglicherweise fließender Ableitstrom ungefährlich niedrig (< 10 μA).

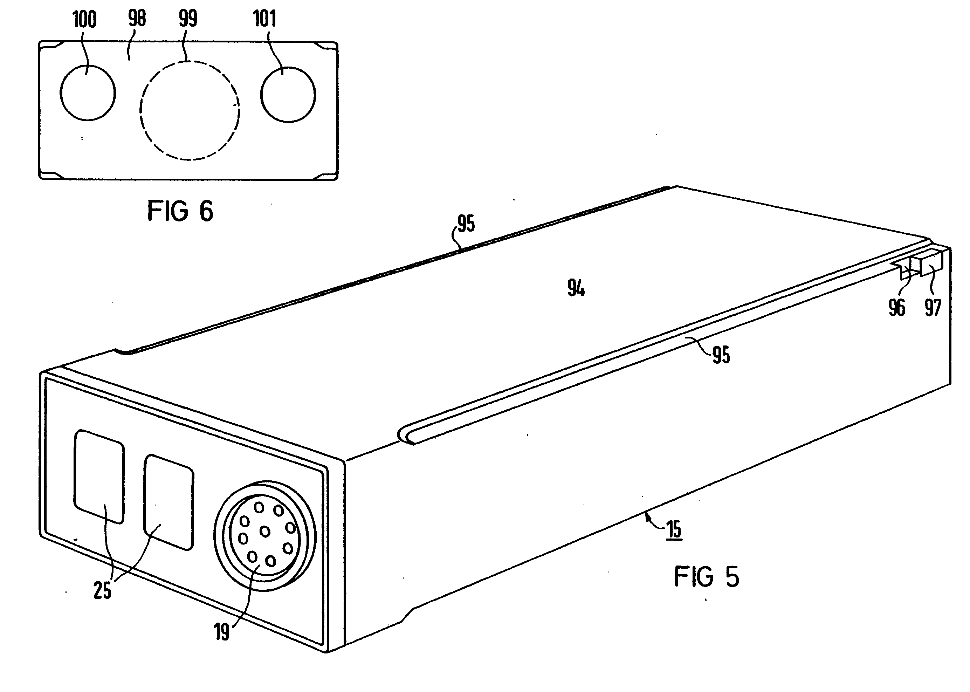

In der Figur 2 umfassen die beiden Halbschalen 34 und 35 des Isolierkörpers 13 an den einander zugewandten Montierkanten Bolzen 37 an jeweils einer Montierkante des einen Halbteiles, die zu entsprechenden Justierlöchern 38 an der Gegenkante des anderen Halbteiles passen. Nach Zusammenfügen der beiden Halbschalen 34 und 35 werden diese an den Aneinandersetzleisten frontseitig über Schraublöcher 39 auf der Deckseite und entsprechende Schraublöcher 39 auf der Grundseite mit je einer Schraube miteinander verschraubt. Entsprechendes gilt für zwei Eckschraublöcher 40 im hinteren Teil Deckfläche der Halbschalen 34, 35. die über entsprechende Ecklöcher an der Oberkante einer ansetzbaren Rückwand mit der Rückwand verschraubbar sind. Die Unterflächen der beiden Halbschalen 34, 35 werden hingegen rückseitig durch eine spezielle Ausformung der Rückwand zusammengepreßt, die in zwei Nuten 41, 42 an den rückseitigen Längskanten der zusammengesetzten Halbschalen 34 und 35 einschiebbar ist. Bei eingeschobener Rückwand bildet dann der aus den beiden Halbschalen 34, 35 zusammengesetzte Isolierkörper 13 einen frontseitig offenen Kasten, in den die Einschübe 15 bis 18 eingeschoben werden können. Zum etagenmäßigen Einschieben der einzelnen Einschübe 15 bis 18 haben die beiden Halbschalen 34, 35 an ihrer Innenwandung Längs-, Gleit- oder Führungsschienen 43 bis 46. Diese Längsschienen 43 bis 46 sind so geformt, daß auf eine relativ flache Wandauswölbung 47 ein stärker ausgewölbter Längssteg 48 (dargestellt am Beispiel der Längsschiene 44) folgt. Dies hat zum Ergebnis, daß der einzuschiebende Einschub 15 bis 18, getragen vom jeweiligen Längssteg 48 einer Längsschiene 43 bis 46, nur auf der leichten Auswölbung 47, d. h. nicht mit der gesamten Seitenfläche an der gesamten Innenwand des Isolierkörpers 13, gleitet. Hierdurch ergibt sich eine besonders reibarme Bedienweise des Einschubes 15 bis 18. Die Stegauswölbungen 47, 48 sind leicht abgerundet ; der ausgewölbte Mittelsteg 48 paßt zu einer entsprechenden Längs- oder Gleitrille (vgl. Gleitrinne 95 in Fig. 5) an den Längskanten eines jeden Einschubes 15 bis 18. Die Längsschienen 43 bis 46 und die Gleitrillen an den Einschüben 15 bis 18 sorgen aufgrund ihrer Abgerundetheit nicht nur für reibarmes Gleiten ; die abgerundeten Stege und Gleitrillen vermeiden auch scharfe Kanten, an denen sich leicht Schmutz ansetzt.

Diese Art von Gleitlagerung ist also auch nach Gesichtspunkten der Reinlichkeit optimal ausgelegt.

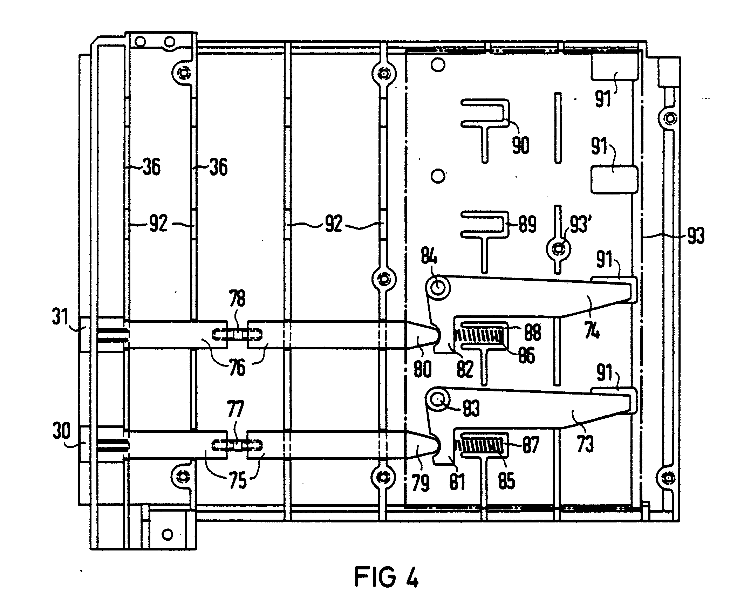

In der Figur 2 sind an der rechten Außenkante der Halbschale 34 die Ausklinktasten für das Arretierhebelsystem wieder mit 30 bis 33 angedeutet. Die Tasten 30 bis 33 ragen dabei nur um einen solchen Wegbetrag aus Öffnungen 49 bis 52 der Kante der Halbschale 34 hervor, daß nach Montage des Isolierkörpers 13 in der Kammer 12 des Gerätegehäuses 1 bei Abdeckung der Frontfläche 5 mit der Folie die Stirnfläche jeder Klinktaste 30 bis 33 in etwa in der Ebene der Abdeckfolie der Frontplatte 5 liegt. Die Betätigung einer Ausklinktaste 30 bis 33 erfolgt dann durch Druck auf die Folie an der Stelle der Ausklinktaste. Das Drücken einer Ausklinktaste 30 bis 33 bewirkt, daß im vorliegenden Fall über ein Hebelsystem ein Klinkhebel betätigt wird. Die Arretiernasen der jeweiligen Klinkhebel, die im eingeschobenen Zustand des Einschubes 15 bis 18 in eine Nut an einer Seitenkante des Einschubes eingreifen, sind in der Figur 2 an der hinteren Innenseite der rechten Halbschale mit 53 bis 56 angedeutet. Nähere Einzelheiten über Aufbau und Funktionsweise der Arretiervorrichtung ergeben sich aus der noch folgenden Beschreibung zur Figur 4.

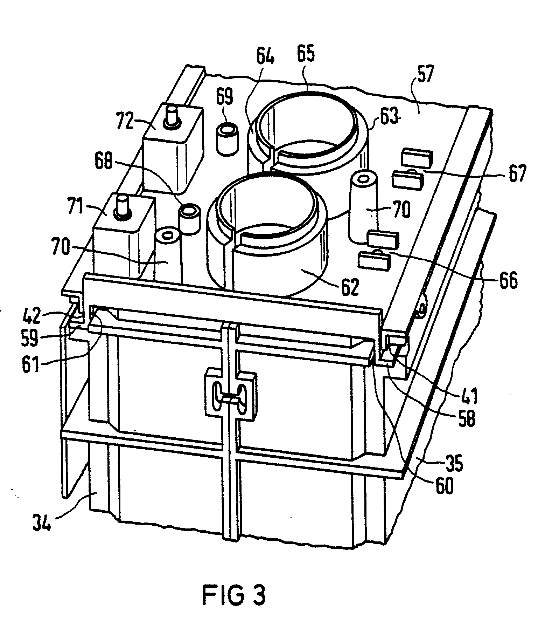

Figur 3 zeigt in teilweise gebrochener Ansicht die zum Ganzkörper zusammengefügten Halbschalen 34 und 35 schräg von unten und gegenüber der Darstellung der Figur 2 um ca. 180° gedreht. Mit eingezeichnet ist jetzt die in die Nuten 41 und 42 eingeschobene Rückplatte 57. Die Nutstege 58 und 59 dieser Rückplatte 57 gleiten am untersten Ende kurz vor vollständigem Einschieben der Platte über zwei leicht geschrägte Flächen 60 und 61 an der hinteren Unterkante der Unterflächen der beiden Halbschalen 34 und 35. Die Nutstege 58, 59 üben damit an ihren Unterkanten über die zunehmende Schrägfläche 60 bzw. 61 Druck auf die Unterseiten der beiden Halbschalen 34, 35 aus. Die beiden Halbschalen 34, 35 werden an dieser Stelle zusammengedrückt und haften damit gut aneinander. Die Rückplatte 57 besteht ebenfalls aus Kunststoff, vorzugsweise wieder ABS. Sie ist nicht nur rückwärtiges Abschlußteil des Isolierkörpers 13 ; die Rückplatte 57 dient auch als Träger für jene Teilglieder der Koppelstelle, die als geräteseitige Halbteile zu den Halbteilen im Inneren der Einschübe 15 bis 18 passen. In der Figur 3 weist die Rückplatte 57 insgesamt vier Aufnahmezylinder für Übertragerkörper zur Energieübertragung auf, von denen allerdings wegen der teilgebrochenen Darstellung nur zwei zu sehen sind, die mit 62 und 63 bezeichnet sind. Der obere, der Rückplatte 57 abgewandte Rand eines jeden Montagezylinders 62, 63 etc. ist stegartig verdünnt. Die Schulter 64 der Stegverdünnung des Oberrandes dient dabei als Auflage für eine Montageplatte, die durch den eigentlichen Oberrand-Rundsteg 65 zentriert wird. Die Montageplatte ist wiederum Träger der Übertragerkörper in schwimmender Aufhängung ; sie selbst sitzt auf einer Leiterplatte, auf der die für die Energieübertragung bzw. Signalübertragung erforderlichen elektronischen Bauelemente montiert sind. Im vorliegenden Fall erfolgt die Signalübertragung vom Einschub in Richtung der Signalverarbeitungsteile des Gerätes mittels Lumineszenzdioden, vorzugsweise im Infrarotbereich. Zu diesem Zwecke sind für insgesamt vier Sendedioden, die als primäre Signalkoppelglieder im jeweiligen Einschub 15 bis 18 angeordnet sind, auf der Rückplatte 57 vier geräteseitige Lichtempfänger (z. B. Fotodioden) als sekundäre Signalkoppelglieder vorgesehen. Die Montagenischen für die Lichtempfänger sind auf der Montageplatte 57 mit den Kennzeiffern 66, 67 etc. angegeben. Entsprechend sind auch für die Signalübertragung (Schalt- oder sonstige Steuersignale) vom Inneren des Gerätegehäuses 1 in Richtung der Einschübe 15 bis 18 auf der Rückplatte 57 des Isolierkörpers 13 Einsätze 68, 69 etc. für Sendedioden vorgesehen. Die dort einzusetzenden Lumineszenzdioden sind die primären Koppelglieder für einen Sendefall ; die zugeordneten Empfänger sitzen als sekundäre Koppelglieder innerhalb des Einschubgehäuses. Wird ein Einschub 15 bis 18 in eine Etage des Isoliergehäuses 13 bis in seine Endstellung eingeschoben, so ergibt sich automatisch Koppelverbindung zwischen Koppelgliedern für die Energieübertragung vom Gerät zum Einschub und Koppelgliedern für die Signalübertragung sowohl vom Einschub in Richtung Gerätegehäuse 1 als auch vom Gerätegehäuse 1 in Richtung Einschub. Im Ausführungsbeispiel der Figur 3 umfaßt darüber hinaus die Rückplatte 57 noch Schraubfüße 70 zum Festschrauben der die Montageplatte tragenden Leiterplatte, und an der linken Seite der Rückplatte 57 sind die ersten beiden Auswerfer 71 und 72 von insgesamt vier Auswerfern für je einen Einschub zu sehen.

Figur 4 zeigt, wie schon vorstehend angedeutet, die — von der Öffnung her gesehen — rechte Seitenwand des Isolierkörpers 13, an der das Hebelsystem für die Arretierung der einzelnen Einschübe 15 bis 18 montiert ist. Dieses Hebelsystem umfaßt dabei für jeden Einschub 15 bis 18 einen Klinkhebel 73, 74 etc. mit den in der Figur 2 dargestellten Arretiernasen 53 bis 56. Jedem Klinkhebel 73, 74 etc. ist ein Betätigungshebel 75, 76 etc. zugeordnet, der bei Druck auf die endständige Ausklinktaste 30, 31 etc. ausgelenkt wird und den Klinkhebel betätigt. Jeder Auslenkhebel 75, 76 etc. besteht dabei aus zwei Teilen, die durch je eine Justierschraube 77, 78 etc. auf eine gewünschte Gesamtlänge des Hebels einjustierbar sind. Jeder Auslenkhebel 75, 76 etc. stößt darüber hinaus über ein zugespitztes Ende 79, 80 etc. in eine Mulde des der Arretiernase abgewandten, um etwa 90° abgekröpften Endes des Klinkhebels 73, 74 etc. Bei Druck auf diese Mulde wird demnach der Hebel um sein Drehgelenk 83, 84 etc. gegen den Druck einer Feder 85, 86 etc., die in einer Nische 87, 88, 89, 90 der Seitenwand gelagert ist, einwärts geschwenkt. Diese Einwärtsschwenkung des einen Hebelendes führt zu einer Aufwärtsschwenkung des anderen Hebelendes mit der Arretiernase 53 bis 56. Die durch die Seitenwandöffnung 91 in das Innere des Isolierkörpers 13 greifende Arretiernase 53 bis 56 wird nach oben angehoben. Die Arretiernase 53 bis 56 springt aus der entsprechenden Arretiernut des Einschubes, und der Einschub wird im selben Augenblick durch den Auswerfmechanismus aus dem Isoliergehäuse 13 ausgeworfen. Bei der Arretiervorrichtung der Figur 4 sind die Längshebel 75, 76 etc. in Nischen 92 der Rippen der Seitenwand eingelagert. Zur Sicherung der Klinkhebel 73, 74 nebst Federn 85, 86 gegen Herausspringen aus ihren Halterungen dient eine (strichpunktiert dargestellte) Kunststoffplatte 93, die in einem Schraubloch 93' an der Seitenwand des Isoliergehäuses 13 über den Hebeln und Federn angeschraubt wird.

Figur 5 zeigt ein Ausführungsbeispiel eines Einschubes, beispielsweise des Einschubes 15 in der Figur 1. Jeder der Einschübe 15 bis 18 umfaßt ein nur frontseitig offenes Mantelgehäuse 94 aus hochisolierendem Kunststoff, z. B. wieder ABS. Der hochisolierende Mantel 94 ist entlang seiner Längskanten mit den schon erwähnten wohlgerundeten und deshalb auch leicht zu säubernden Gleitrinnen 95 versehen. Am hinteren Ende der rechten oberen Kante des Mantelgehäuses 94 befindet sich eine Einklinknut 96, in die ein Block 97 aus hartem Kunststoff, insbesondere Polyamid-Glasfaser, eingeklebt ist. Der harte Block 97 schützt die Einklinknut 96 gegen allzu starke Beanspruchung durch die Arretiernase des Klinkhebels. Die Frontöffnung des Mantelgehäuses 94 eines jeden Einschubes 15 bis 18 ist mit einer Einschubfrontplatte 118 dicht abgeschlossen.

Figur 6 zeigt die Rückwand 98 des Mantelgehäuses 94. Diese Rückwand 98 ist im Zentrum (gestrichelt angedeutet) im Material scheibenartig verdünnt. Die Verdünnung an dieser Stelle gewährleistet eine besonders enge Ankopplung des dahinterliegenden Übertragungskörpers auf der Seite des Einschubes an jenen auf der Seite des Gerätes an der Rückplatte des Isolierkörpers 13 in der Endstellung des Einschubes. Mit 100 und 101 sind zwei Fenster für das Infrarotlicht der beiden Signalübertragungskoppler eines jeden Einschubes 15 bis 18 angedeutet. Bei dem Fenster 100, 101 handelt es sich um rot eingespritzten Kunststoff oder um ein echtes Infrarotfilter. Die beiden Fenster 100, 101 sind wasser- und luftdicht sowie hochspannungsfest und durch Ultraschall in die Rückwand 98 eingeschallt.

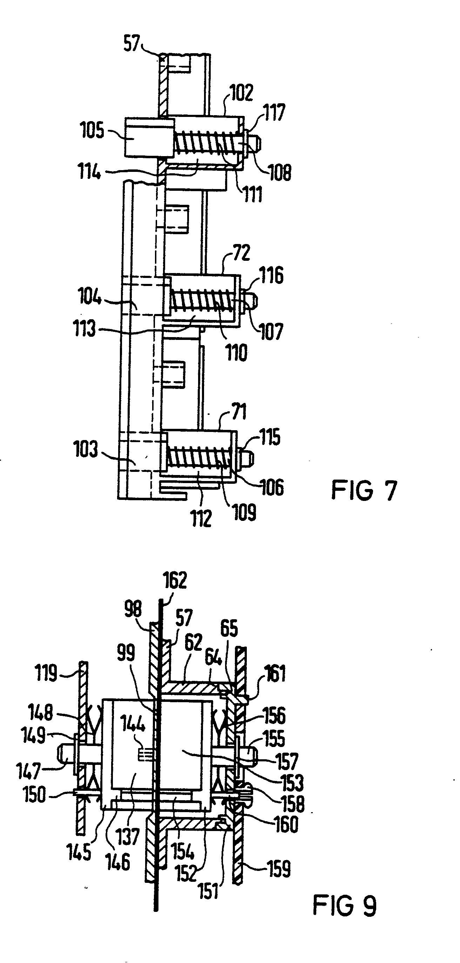

Figur 7 zeigt im Detail den Auswerfmechanismus an der Rückplatte 57 des Isolierkörpers 13. Zusätzlich zu den Auswerfblöcken 71, 72 der Figur 3 ist noch ein dritter Auswerfblock 102 dargestellt. Ein vierter Auswerfblock ist wegen der gebrochenen Darstellung nicht mehr mit eingezeichnet. Jeder Block 71, 72, 102 etc. umfaßt ein Stoßglied 103, 104, 105 etc. Jedes dieser Stoßglieder ist mit einem Stößel 106, 107, 108 etc. verbunden, der durch eine Schraubenfeder 109, 100, 111 etc. im Innenraum 112, 113, 114 etc. der jeweiligen Auswerfblöcke federnd gehalten ist.

Zur äußeren Sicherung der Stößel dienen Sicherungsringe 115, 116, 117 etc. Wird also ein Einschub 15 bis 18 in die ihm zugeordnete Etage des Isoliergehäuses 13 eingeschoben, so wird durch die Rückwand des Einschubes das sich in Höhe dieser Etage befindende Stoßglied 103 bis 105 samt Stößel 106 bis 108 etc. gegen den Druck der den Stößel umgreifenden Feder 109 bis 111 nach hinten geschoben. Der in seiner Endstellung schließlich durch die Arretiernase 53 bis 56 des Klinkhebels 73, 74 etc. in seiner Rastnut 96 festgehaltene Einschub 15 bis 18 drückt nun so lange auf das Stoßglied 103 bis 105 etc., bis durch Druck auf die zugehörige Ausklinktaste 30 bis 33 des Arretierhebelsystems die Arretierung durch den Klinkhebel gelöst wird. Die Federkraft der gespannten Feder 109 bis 111 sorgt dann dafür, daß der Einschub 15 bis 18 durch das Ausstoßglied 103 bis 105 aus dem Inneren des Isolierkörpers 13 zumindest so weit herausgestoßen wird, daß er an seiner Frontseite von Hand bequem ergriffen und herausgezogen werden kann. Jeder Stößel 106, 107, 108 etc. betätigt in bevorzugter Ausbildung auch noch einen Schalter, insbesondere Mikroschalter, in dem Sinne, daß mit Auswerfen eines Einschubes 15 bis 18 die Stromzufuhr zum Primärübertrager auf der Geräteseite unterbrochen wird.

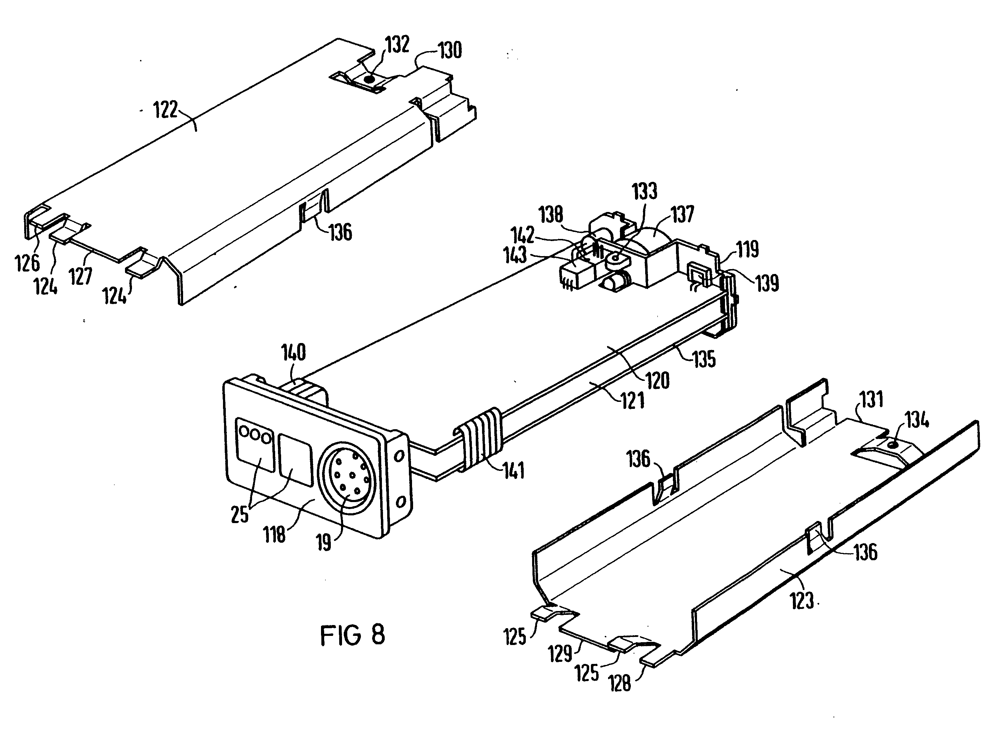

Figur 8 zeigt als Ausführungsbeispiel den inneren Aufbau eines Einschubes 15 bis 18. Dieser innere Aufbau ist dadurch gekennzeichnet, daß zwischen dem Frontteil 118 des Einschubes und einem Rückteil 119 nach Art einer Steckverbindung insgesamt zwei Leiterplatten 120 und 121 gehaltert sind. Auf diesen Leiterplatten 120, 121 sind die wesentlichen elektronischen Bauelemente für Energie- und Signalübertragung montiert. Dieser Teilaufbau aus Front- und Rückteil 118 bzw. 119 sowie Leiterplatten 120, 121 ist schließlich nach Sandwich-Art durch zwei metallische Abschirmbleche 122 und 123 (z. B. aus Aluminium oder Stahlblech) abgedeckt. Beide Abschirmbleche 122 und 123 sind an der Vorderkante mit Klauen 124 bzw. 125 versehen. Bei Auflage des jeweiligen Bleches 122, 123 mit den ebenen Kanten 126, 127 bzw. 128, 129 auf die Innenschulter der Frontplatte 118 greifen die Klauen 124 bzw. 125 in Ausnehmungen unterhalb der Schulter, so daß sich an der Schulter eine Art Klemmverbindung zur Halterung der Vorderkante der beiden Bleche 122 und 123 ergibt. Die Rückkanten 130 bzw. 131 der Bleche 122 und 123 liegen auf den Kanten des Rückteils 119 auf. Sie werden über Schraublöcher 132, 133 bzw. 134, 135 mit dem Rückteil verschraubt. Die mittleren Teile der Abschirmbleche 122, 123 liegen über Klauen 136 federnd an den Seitenkanten der Leiterplatten 120 und 121 an. Im Ausführungsbeispiel der Figur 8 ist das Rückteil 119 zum Zwecke der Abschirmung aus metallisiertem Kunststoff gefertigt. Das Rückteil 119 ist gleichzeitig Träger von Halbteilen von Koppelstellen zur Energie- und Signalübertragung. So trägt es u. a. in schwimmender Aufhängung einen Schalenkern zur Aufnahme eines Spulenkörpers als Sekundärteil einer Koppelstelle für Energieübertragung vom Gerät zum jeweiligen Einschub 15 bis 18. Zur Signalübertragung vom Einschub zum Gerät sind an der linken Seite ein Einsatz für eine Sendediode 138 (Lumineszenzdiode) und zur Signalübertragung vom Gerät zum Einschub auf der rechten Seite eine Nische für einen Lichtempfänger 139 (Fotodiode) angeordnet. Zur leitungsmäßigen Verbindung zwischen Vorderplatte 118 (Folienfrontplatte mit integrierten Schaltern) des Einschubes und Leiterplatten 120, 121 dient ein Signalkabelstrang 140, während zur Verbindung der Leiterplatten 120, 121 untereinander ein Signalkabelstrang 141 vorgesehen ist. Zur Herstellung einer Leitungsverbindung für die Energieübertragung vom im Schalenkern 137 sitzenden Spulenkörper zum zugehörigen Schaltungsteil auf den Leiterplatten 120, 121 dient eine Steckverbindung 142, 143. Der Stecker 142 sitzt am Rückteil 119 ; der Stecker 143 ist auf der Leiterplatte 120 angeordnet. Im montierten Zustand kann das gesamte Gebilde der Figur 8 in das hochisolierende Mantelgehäuse 94 des Einschubes von der Frontseite her eingeschoben werden. Es entsteht somit ein Einschub, wie er in der Figur 5 dargestellt ist.

Figur 9 zeigt im Ausschnitt eine Koppelstelle für Energieübertragung, wie sie sich darstellt, wenn ein Einschub 15 bis 18 in seine Endstellung im Isoliergehäuse 13 gebracht ist. Mit 98 ist in gebrochener und geschnittener Darstellung wieder die Rückwand des Einschubgehäuses 94 mit Materialverdünnung 99 im Zentrum dargestellt. Die Materialverdünnung 99 ist auch noch mit einem Zentrierkreuz 144 versehen. Mit 145 ist der Übertragerträger bezeichnet. Dieser Träger 145 trägt den schon in der Figur 8 dargestellten einschubseitigen Schalenkern 137 zur Aufnahme des sekundärseitigen Spulenkörpers. Der Schalenkern 137 ist geschlitzt ; durch den Schlitz 146 sind gleichzeitig die Anschlußdrähte für den Spulenkern geführt. Der Übertragerträger samt Schalenkern und Spulenkörper ist mittels eines Haltenippels 147 unter Einschluß einer Feder 148 am Rückteil 119 federnd aufgehängt. Ein Sicherungsring 149 sichert die Anordnung gegen Herausfallen.

Eine ähnliche Bauweise bietet auch die Aufhängung des Übertragers auf der Seite des Gerätes. Mit 57 ist wieder die Rückplatte des Isoliergehäuses 13 dargestellt. Die Rückplatte 57 trägt entsprechend Figur 3 z. B. den Montagezylinder 62 mit Schulter 64 und Zentriersteg 65 der Stegverdünnung des Oberrandes. Auf dem so gestalteten Oberrand des Aufnahmezylinders 62 sitzt die Montageplatte 151 für einen geräteseitigen Übertragerträger 152 mit montiertem Schalenkern 153 mit Schlitz 154 für den geräteseitigen Spulenkörper. Das Übertragergebilde ist wieder mittels Haltenippel 155 und Feder 156 sowie Sicherungsring 157 schwimmend an der Montageplatte 151 aufgehängt. Träger der Montageplatte 151 ist eine Leiterplatte 159, die die für Energie- und Signalübertragung nötigen elektronischen Bauelemente trägt. Zur Befestigung der Montageplatte auf der Leiterplatte dient ein Schnappnippel 158, der in die Leiterplatte einfach eingeschnappt wird. Zur Sicherung gegen Verdrehung dient zwischen Übertragerträger und Montageplatte wieder ein Montagestift 160 und zwischen Montageplatte und Leiterplatte ein Stift 161, während 162 eine sehr dünne Dichtfolie ist, die über die Innenfläche der Rückplatte 57 gespannt ist.

Bei dem dargestellten Gerät wird also nicht nur erreicht, daß auch bei großvolumiger bzw. großflächiger Ausbildung der Einsteckverbindung koppelkapazitäten zwischen Metallteilen im Inneren der Einschübe 15 bis 18 und Metallteilen im Inneren des Gerätegehäuses 1 klein gehalten werden, so daß auch der Ableitstrom vernachlässigbar klein wird ; durch die besondere Formgebung des Isolierkörpers 13 und durch dessen funktionsgerechten Zusammenbau mit weiteren Bauteilen, wie z. B. Auswerfmechanismus in Verbindung mit Arretiervorrichtung, durch die bauliche Zuordnung der Einzelbestandteile jeder Koppelstelle zueinander, etc. ist darüber hinaus ein Gerät geschaffen, das optimal und platzsparend einsetzbar ist.

**Patentansprüche**

1. Isolierter Einschub (15 bis 18) von hoher Spannungsfestigkeit zum Einschieben in die Kammer (12) eines Gerätegehäuses (1), mit einem Mantelgehäuse (94) aus hochisolierendem Kunststoff, das eine metallische Abschirmung (122, 123) und innerhalb dieser Abschirmung (122, 123) Bauelemente (138, 139 ; 134, 153) enthält, die zur Energie und/oder Signalübertragung vorgesehen sind, dadurch gekennzeichnet, daß im Mantelgehäuse (94) ein Schichtpaket angeordnet ist, das zwei metallische Abschirmbleche (122, 123), z. B. aus Aluminium oder Stahlblech, und zwei nach Sandwich-Art dazwischen gelagerte Leiterplatten (120, 121) als Träger für die zur Energie und/oder Signalübertragung vorgesehenen Bauelemente umfaßt, daß das Mantelgehäuse (94) nur an seiner Frontseite offen ist und dort eine Frontöffnung bildet, daß zum Abschluß der Frontöffnung eine Frontplatte (118) vorgesehen ist, die in ihren Abmessungen dicht in die Frontöffnung paßt, daß die Leiterplatten (120, 121) vorderseitig an der Frontplatte (118) und rückseitig an einem Rückteil (119) montiert sind, daß die beiden metallischen Abschirmbleche (122, 123) teilweise in Steckverbindung (124 bis 129) und teilweise in Schraubverbindung (132 bis 135) mit der Frontplatte (118) und dem Rückteil (119) verbunden sind, und daß das Schichtpaket (120 bis 123) samt Rückteil (119) in das Mantelgehäuse (94) einschiebbar ausgebildet ist.

2. Einschub nach Anspruch 1, dadurch gekennzeichnet, daß das Mantelgehäuse aus Amino-Butadien-Styrol (ABS) besteht.

3. Einschub nach Anspruch 1 oder 2, dadurch gekennzeichnet, daß für die Steckverbindung mit der Frontplatte (118) jedes Abschirmblech (122, 123) an der Vorderkante mit Klauen (124, 125) versehen ist, die so ausgebildet sind, daß sie bei Auflage des jeweiligen Abschirmbleches mit verbleibenden ebenen Kanten (126, 127 bzw. 128, 129) auf eine Innenschulter der Frontplatte (118) in Ausnehmungen unterhalb der Schulter greifen, so daß sich an der Schulter eine Art Klemmverbindung zur Halterung der Vorderkante der beiden Abschirmbleche ergibt.

4. Einschub nach einem der Ansprüche 1 bis 3, dadurch gekennzeichnet, daß zur Herstellung der Schraubverbindung die Rückkanten (130 bzw. 131) der Abschirmbleche (122, 123) auf Kanten des Rückteiles (119) liegen und im Nahbereich der Auflagestellen über Schraublöcher (132, 133 bzw. 134, 135) mit dem Rückteil (119) verschraubbar sind.

5. Einschub nach einem der Ansprüche 1 bis 4, dadurch gekennzeichnet, daß die mittleren Teile der Abschirmbleche (122, 123) über Klauen (136) federnd an den Seitenkanten der dazwischen angeordneten Leiterplatten (120, 121) anliegen.

6. Einschub nach einem der Ansprüche 1 bis 5, dadurch gekennzeichnet, daß zum Zwecke weiterer Abschirmung das Rückteil (119) aus metallisiertem Kunststoff gefertigt und die Frontplatte (118) ebenfalls mit einer metallischen Abschirmschicht versehen ist.

7. Einschub nach einem der Ansprüche 1 bis 6, dadurch gekennzeichnet, daß das Rückteil (119) und/oder die Leiterplatten (120, 121) Träger von Halbteilen (137 bis 139) einer galvanisch trennenden Koppelstelle sind, deren dazu passenden anderen Halbteile in der Kammer (12) sitzen, wobei sich die Halbteile zu einer Koppelstelle für Energie- und/oder Signalübertragung zwischen Einschub und Geräteinnerem zusammenfügen, wenn der Einschub (15 bis 18) in die Kammer (12) eingesteckt ist.

8. Einschub nach Anspruch 7, dadurch gekennzeichnet, daß das Rückteil (119) in schwimmender und federnder Aufhängung das einschubseitige Halbteil (137 bis 139) eines Energieübertragers zur Übertragung von Energie vom Gerät (1) zum Einschub (15 bis 18), oder umgekehrt, trägt.

9. Einschub nach Anspruch 7 oder 8, dadurch gekennzeichnet, daß das Rückteil (119) oder eine der Leiterplatten (120, 121) gleichzeitig Träger von Nischen oder Einsätzen ist, in denen Lichtsender (138), z. B. Lumineszenzdioden, als primäres Signalkoppelglied zur Signalübertragung vom Einschub in das Gerät oder Lichtempfänger (139), z. B. Fotodioden, als sekundäres Signalkoppelglied zur Übertragung von Signalen vom Gerät zum Einschub positionierbar sind, daß diejenige Wand des Mantelgehäuses (94), insbesondere die Rückwand (98), die eine isolierte Trennwand zwischen einem Übertragerhalbteil (137, 145, 146) auf der Seite des Einschubes (15 bis 18) und dem dazu passenden Übertragerhalbteil auf der Seite der Kammer (12) bildet, über eine Fläche (99), die in etwa der Fläche eines Übertragerhalbteiles entspricht, im Material verdünnt ist (z. B. ≤ 1 mm), um den Abstand an der Übertragungsstelle klein und damit die Energieverluste gering zu halten, und daß in derjenigen Wand (98) des Mantelgehäuses (94), über die Lichtübertragung stattfinden soll, auf das durchzulassende Licht abgestimmte Kunststoffenster (100, 101) wasser- und luftdicht sowie hochspannungsfest angeordnet sind.

**Claims**

1. An insulated plug-in unit (15 to 18) having high voltage-stability for insertion into the chamber (12) of an apparatus housing (1), comprising a casing (94) made of a highly insulating synthetic resin and which contains a metallic screen (122, 123) and components (138, 139, 153) within the screen (122, 123) which are provided for the transmission of energy and/or signals, characterised in that in the casing (94) a layer packet is arranged which comprises two metal screening sheets (122, 123), made, for example, of aluminium or steel plate, and two circuit boards (120, 121), which are positioned therebetween in the manner of a sandwich, as carriers for the components which are provided for the transmission of energy and/or signals ; that the casing (94) is only open on its front end and there forms a front opening ; that in order to close the front opening a front plate (118) is provided which fits tightly into the front opening in respect of its dimensions ; that the circuit boards (120, 121) are mounted on the front plate (118) at the front end and on a rear component (119) at the rear end ; that the two metal screening sheets (122, 123) are connected to the front plate (118) and the rear component (119) partially in a plug connection (124 to 129) and partially in a screw connection ; and that the layer packet (120 to 123), together with the rear component (119), is designed to be insertable into the casing (94).

2. A plug-in unit as claimed in Claim 1, characterised in that the casing is made of aminobutadiene-styrene (ABS).

3. A plug-in unit as claimed in Claim 1 or Claim 2, characterised in that for the plug connection to the front plate (118), each screening sheet (122, 123) is provided with claws (124, 125) on its front edge, which claws are so designed that on contact of the respective screening sheet with residual plane edges (126, 127 and 128, 129) on an internal shoulder of the front plate (118), they engage into recesses beneath the shoulder, so that a form of clamping connection for supporting the front edge of the two screening sheets is established at the shoulder.

4. A plug-in unit as claimed in one of Claims 1 to 3, characterised in that, in order to establish the screw connection, the rear edges (130 and 131) of the screening sheets (122, 123) rest on edges of the rear component (119) and can be screwed to the rear component (119) by means of screw holes (132, 133 and 134, 135) in close proximity to the contact points.

5. A plug-in unit as claimed in one of Claims 1 to 4, characterised in that the central parts of the screening sheets (122, 123) resiliently rest against the lateral edges of the intermediate circuit boards (120, 121) by way of claws (136).

6. A plug-in unit as claimed in one of Claims 1 to 5, characterised in that, for further screening, the rear component (119) is made of a metallized synthetic resin and the front plate (118) is likewise provided with a metal screening layer.

7. A plug-in unit as claimed in one of Claims 1 to 6, characterised in that the rear component (119) and/or the circuit boards (120, 121) carry halfsections (137 to 139) of an electrically separating coupling point, whose matching other half-sections are located in the chamber (12), the halfsections being assembled between the plug-in unit and the inside of the apparatus to form a coupling point for the transmission of energy and/or signals when the plug-in unit (15 to 18) is inserted into the chamber (12).

8. A plug-in unit as claimed in Claim 7, characterised in that the rear component (119) supports at the end of the plug-in unit, the halfsection (137 to 139) of an energy transmitter for transmitting energy from the apparatus (1) to the plug-in unit (15 to 18), or *vice versa*, in a floating or resilient suspension.

9. A plug-in unit as claimed in Claim 7 or Claim 8, characterised in that the rear component (119), or one of the circuit boards (120, 121), simultaneously carries recesses or inserts, into which light transmitters (138), e. g. luminescence diodes, can be positioned as primary signal coupling elements for signal transmission from the plug-in unit to the apparatus, or light receivers (139), e. g. photodiodes, can be positioned as secondary signal coupling elements for the transmission of signals from the apparatus to the plug-in unit ; that the wall of the casing (94), in particular the rear wall (98), which forms an insulated partition between a transmitter halfsection (137, 145, 146) on the side of the plug-in unit (15 to 18) and the matching transmitter halfsection on the side of the chamber (12), is reduced in thickness of material (e. g. ⩽ 1 mm) by means of a surface (99) which approximately corresponds to the surface of a transmitter halfsection in order to keep the distance at the transmission point small and thus the energy losses low ; and that in the wall (98) of the casing (94), by means of which light transmission is to be effected, plastics windows (100, 101) adapted to the light to be transmitted are arranged so as to be water-proof and air-tight and stable as regards high-voltage.

## Revendications

1. Tiroir isolé (15 à 18) présentant une rigidité diélectrique élevée, destiné à être inséré dans la chambre (12) d'un boîtier d'appareil (1), et comportant une enveloppe de boîtier (94) constituée en une matière plastique très isolante, et pourvue d'un blindage formant écran métallique (122, 123) et, dans celui-ci des composants (138, 139 ; 134, 135) qui sont prévus pour la transmission de l'énergie et/ou des signaux, caractérisé par le fait que dans l'enveloppe de boîtier (94) se trouve disposé un paquet stratifié, qui comporte deux tôles-écrans métalliques (122, 123), constituées par exemple en aluminium ou en une tôle d'acier, et deux plaquettes à circuits imprimés (120, 121) intercalées entre ces tôles selon une disposition en sandwich et qui servent de support pour les composants prévus pour la transmission de l'énergie et/ou pour la transmission des signaux, que l'enveloppe (94) est ouverte uniquement sur sa face avant et délimite en cet endroit une ouverture frontale, que pour le raccordement de l'ouverture frontale il est prévu une plaque frontale (118) dont les dimensions sont étroitement adaptées à l'ouverture frontale, que les plaquettes à circuits imprimés (120, 121) sont montées, du côté avant, sur la plaque frontale (118) et du côté arrière, sur un élément postérieur (119), que les deux tôles métalliques (122, 123) formant écrans sont reliées, partiellement selon une liaison à enfichage (124 à 129) et partiellement selon une liaison vissée (132 à 135), à la plaque frontale (118) et à l'élément postérieur (119) et que le paquet stratifié (122, 123) y compris l'élément postérieur (119), est réalisé de manière à pouvoir être inséré dans l'enveloppe (94).

2. Tiroir suivant la revendication 1, caractérisé par le fait que l'enveloppe de boîtier est constituée par de l'acrylonitrile-butadiène-styrène (ABS).

3. Tiroir suivant la revendication 1 ou 2, caractérisé par le fait que pour la liaison à enfichage avec la plaque frontale (118), chaque tôle formant écran (122, 123) comporte sur son bord avant des griffes (124, 125) qui sont agencées de telle sorte que lors de l'application de la tôle formant écran, elles pénètrent par des bords plans qui subsistent (126, 127 ou 128, 129) sur un épaulement intérieur de la plaque frontale (118), dans des évidements situés au-dessous de l'épaulement de telle sorte que l'on obtient au niveau de l'épaulement une sorte de liaison de blocage servant à maintenir le bord avant des deux tôles formant écran.

4. Tiroir suivant l'une des revendications 1 à 3, caractérisé par le fait que pour l'établissement de la liaison vissée, les bords arrière (130 ou 131) des tôles formant écran (122, 123) sont situés sur des bords de l'élément postérieur (119) et sont susceptibles d'être vissés, au voisinage des points d'application, par l'intermédiaire de trous taraudés (132, 133 ou 134, 135) à l'élément postérieur (119).

5. Tiroir suivant l'une des revendications 1 à 4, caractérisé par le fait que les parties médianes des tôles formant écran (122, 123) s'appliquent élastiquement, par l'intermédiaire de griffes (136), contre les bords latéraux des plaquettes à circuits imprimés (120, 121), qui sont intercalées entre elles.

6. Tiroir suivant les revendications 1 à 5, caractérisé par le fait qu'en vue de réaliser un blindage supplémentaire, l'élément postérieur (119) est réalisé en une matière plastique métallisée et que la plaque frontale (118) est également munie d'une couche métallique de blindage.

7. Tiroir suivant l'une des revendications 1 à 6, caractérisé par le fait que l'élément postérieur (119) et/ou les plaquettes à circuits imprimés (120, 121) sont des supports de moitiés (137 à 139) d'un point de couplage à séparation galvanique, dont les autres moitiés, qui s'adaptent aux précédentes, sont situées dans la chambre (12), les moitiés s'assemblant de manière à former un point de couplage pour la transmission de l'énergie et/ou des signaux entre le tiroir et l'intérieur de l'appareil, lorsque le tiroir (15 à 18) est enfiché dans la chambre (12).

8. Tiroir suivant la revendication 7, caractérisé par le fait que l'élément postérieur (119) porte, selon un mode de suspension flottant et élastique, la moitié (137 à 139), située du côté du tiroir, d'un transformateur d'énergie pour la transmission de l'énergie de l'appareil (1) au tiroir (15 à 18) ou inversement.

9. Tiroir suivant la revendication 7 ou 8, caractérisé par le fait que l'élément postérieur (119) ou l'une des plaquettes à circuits imprimés (120, 121) constituent en même temps le support de niches ou d'inserts, dans lesquels des sources de lumière (138), par exemple des diodes luminescentes, peuvent être positionnées en tant qu'organes primaires de couplage des signaux pour la transmission de signaux depuis le tiroir vers l'appareil, ou bien des récepteurs de lumière (139), par exemple des photodiodes, peuvent être positionnées en tant qu'organe secondaire de couplage de signaux pour la transmission de signaux de l'appareil vers le tiroir, que la paroi de l'enveloppe de boîtier, notamment la paroi postérieure (98) qui forme une paroi de séparation isolée entre une moitié (137, 145, 146) du transformateur située d'un côté du tiroir (15 à 18) et la moitié du transformateur, qui est adapté à la première moitié, et située sur le côté de la chambre (12), est amincie (par exemple ≤ 1 mm) sur une surface (99), qui correspond approximativement à une surface d'une moitié du transformateur, afin de conserver une faible valeur à la distance au niveau du point de transmission et de maintenir par conséquent à une faible valeur les pertes d'énergie, et que des fenêtres en matière plastique (100, 101), qui sont accordées sur la lumière devant être transmise, sont disposées, d'une manière étanche à l'eau et l'air ainsi que de manière à résister à la haute tension, dans la paroi (98) de l'enveloppe de boîtier (94), par l'intermédiaire de laquelle la transmission de la lumière doit s'effectuer.

FIG 1

FIG 2

FIG 3

FIG 4

FIG 6

FIG 5

0 040 753

FIG 7

FIG 9

FIG 8